# EUROPEAN PATENT APPLICATION

(11) **EP 4 734 671 A1**
(43) Date of publication of application: **29.04.2026**
(21) Application number: 25206599.0
(22) Date of filing: 03.10.2025
(51) Int. Cl.: H05K 3/02, H05K 1/03, H05K 1/02, H05K 3/46

(54) **COPPER-CLAD LAMINATE HAVING LOW DIELECTRIC CONSTANT, LOW DIELECTRIC LOSS AND HIGH THERMAL CONDUCTIVITY AND METHOD FOR MANUFACTURING THE SAME**

(30) Priority: 23.10.2024 KR 20240145511; 28.08.2025 KR 20250120705
(71) Applicant: CRHM Co., Ltd., Seoul 04805 (KR)
(72) Inventor: KIM, Jong Hee, 05510 Seoul (KR)
(74) Representative: Zacco Sweden AB

(57) **Abstract**

Disclosed are a copper-clad laminate having a low dielectric constant, low dielectric loss, and high thermal conductivity properties, and a method for manufacturing the same, wherein an insulator substrate having a low dielectric constant, low dielectric loss and high thermal conductivity values is laminated onto a copper-foil layer and a portion of the copper-foil layer is patterned using selective etching such that a circuit pattern having a line width of 40 *µ*m or smaller is designed, such that the copper-clad laminate is used as a digital substrate.

## Description

### BACKGROUND

### Field

The present disclosure relates to a copper-clad laminate having a low dielectric constant, low dielectric loss and high thermal conductivity properties, and a method for manufacturing the same. More specifically, the present disclosure relates to a copper-clad laminate having a low dielectric constant, low dielectric loss and high thermal conductivity properties, and a method for manufacturing the same, wherein an insulator substrate having a low dielectric constant, low dielectric loss and high thermal conductivity values is laminated onto a copper-foil layer and a portion of the copper-foil layer is patterned using selective etching such that a circuit pattern having a line width of 40 µm or smaller is designed, such that the copper-clad laminate is used as a digital substrate.

### Description of Related Art

There is an increasing demand for high performance, high-speed transmission, miniaturization, weight reduction, and thinning of electronic products.

In addition to the demand and trend for the electronic products, in a communication market of 5G or higher in which large-scale data should be transmitted at high speed in a high frequency band, a low-k material having a low signal loss rate is very important.

Accordingly, the development of a substrate having a low dielectric constant that may be applied to communication equipment such as an antenna for high-speed communication and a server board continues.

However, a FR-4 polymer material used as a general substrate material has a relatively large dielectric loss, and thus has a limitation in reducing a dielectric-tangent. Therefore, in order to replace this material, an attempt is underway to use a ceramic material having the dielectric tangent lower than or equal to 1/10 of the dielectric tangent of a polymer material.

Related prior literature includes Japanese Patent Application Publication No. 2001-348488 (disclosed on 2001.12.18), and this document describes a thermally conductive resin composition, a prepreg, a heat-dissipating circuit board, and a heat-dissipating heating component.

### SUMMARY

A purpose of the present disclosure is to provide a copper-clad laminate having a low dielectric constant, low dielectric loss and high thermal conductivity properties, and a method for manufacturing the same, wherein an insulator substrate having a low dielectric constant, low dielectric loss and high thermal conductivity values is laminated onto a copper-foil layer and a portion of the copper-foil layer is patterned using selective etching such that a circuit pattern having a line width of 40 µm or smaller is designed, such that the copper-clad laminate is used as a digital substrate.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

One aspect of the present disclosure provides a method for manufacturing a copper-clad laminate having a low dielectric constant, low dielectric loss and high thermal conductivity, the method comprising: (a) injecting and coating a ceramic ink composition containing ceramic particles in an inkjet printing manner to form a ceramic insulating film having the ceramic particles uniformly dispersed therein; (b) injecting a resin ink composition containing a resin onto the ceramic insulating film in an inkjet printing manner such that the resin ink composition impregnates into pores defined between the ceramic particles; (c) heat-treating the ceramic insulating film impregnated with the resin ink composition at 140 to 200°C for 1 to 6 hours, thereby forming an insulator substrate; and (d) laminating a copper foil layer on the insulator substrate to form the copper-clad laminate, wherein the insulator substrate has a thermal conductivity value in a range of 1.92 to 18 W/mk.

In accordance with some embodiments of the method for manufacturing the copper-clad laminate having the low dielectric constant, low dielectric loss and high thermal conductivity, in the (a), the inkjet printing may be carried out under a temperature of 80 to 140°C.

In accordance with some embodiments of the method for manufacturing the copper-clad laminate having the low dielectric constant, low dielectric loss and high thermal conductivity, in the (a), the ceramic particle may include at least one selected from Al₂O₃, AlN, SiO₂, BaTiO₃-based ceramic, SrTiO₃-based ceramic, PbTiO₃-based ceramic, ferrite, and Pb(Zr, Ti)O₃-based ceramic.

In accordance with some embodiments of the method for manufacturing the copper-clad laminate having the low dielectric constant, low dielectric loss and high thermal conductivity, the ceramic particle may have an average diameter of 10 to 1,000nm.

In accordance with some embodiments of the method for manufacturing the copper-clad laminate having the low dielectric constant, low dielectric loss and high thermal conductivity, in the (a), the ceramic ink composition may be injected at a first speed and at a first spacing, wherein in the (b), the resin ink composition may be injected at a second speed and at a second spacing, wherein the first and second speeds may be equal each other, and the second spacing may be greater than the first spacing.

In accordance with some embodiments of the method for manufacturing the copper-clad laminate having the low dielectric constant, low dielectric loss and high thermal conductivity, in the (b), the resin may include at least one selected from polyacrylates resin, epoxy resin, phenolic resin, polyamide resin, polyimide resin, unsaturated polyester resin, polyphenylene ether resin (PPE), polyphenylenesulfides resin, cyanate ester resin, and benzocyclobutene (BCB).

In accordance with some embodiments of the method for manufacturing the copper-clad laminate having the low dielectric constant, low dielectric loss and high thermal conductivity, the insulator substrate formed in the (c) may include: 5 to 50 vol% of the resin; 0 to 40 vol% of the pores; and the ceramic particles as a remainer.

In accordance with some embodiments of the method for manufacturing the copper-clad laminate having the low dielectric constant, low dielectric loss and high thermal conductivity, a dielectric constant (Dk) and a dielectric loss (Df) of the insulator substrate measured after the (d) and at 10 to 100GHz may satisfy a following: Dk may be 4.9 or smaller and Df may be 0.008 or smaller.

In accordance with some embodiments of the method for manufacturing the copper-clad laminate having the low dielectric constant, low dielectric loss and high thermal conductivity, the method may further comprise performing selective etching of the copper foil layer such that the copper foil layer may be patterned into a circuit pattern having a line width of 40 µm or smaller.

Another aspect of the present disclosure provides a copper-clad laminate having a low dielectric constant, low dielectric loss, and high thermal conductivity, the copper-clad laminate being manufactured by the method as described above, wherein the copper-clad laminate may include the insulator substrate and the copper foil layer laminated onto the insulator substrate, wherein the insulator substrate may include 5 to 50 vol% of the resin, 0 to 40 vol% of the pores, and the ceramic particles as a remainder, wherein each of the ceramic particles may have an average diameter of 10 to 1,000nm, wherein the insulator substrate may have a thermal conductivity value in a range of 1.92 to 18 W/mk.

In accordance with some embodiments of the copper-clad laminate having the low dielectric constant, low dielectric loss and high thermal conductivity, a dielectric constant (Dk) and a dielectric loss (Df) of the insulator substrate measured at 10 to 100GHz may satisfy a following: Dk may be 4.9 or smaller and Df may be 0.008 or smaller.

In this way, the present disclosure realizes a copper-clad laminate having a low dielectric constant, low dielectric loss and high thermal conductivity properties, and a method for manufacturing the same, wherein an insulator substrate having a low dielectric constant, low dielectric loss and high thermal conductivity values is laminated onto a copper-foil layer and a portion of the copper-foil layer is patterned using selective etching such that a circuit pattern having a line width of 40 µm or smaller is designed, such that the copper-clad laminate is used as a digital substrate.

In addition, in the copper-clad laminate having a low dielectric constant, low dielectric loss, and high thermal conductivity properties and the method for manufacturing the same according to an embodiment of the present disclosure, the pores defined between the ceramic particles are filled with the resin ink composition by impregnating the pores formed between the ceramic particles with the resin ink composition using the inkjet printing method, and the resin ink composition is subject to the heat treatment, such that the resin uniformly fills the pores formed between the ceramic particles, thereby manufacturing the insulator substrate having the low dielectric constant and exhibiting the high thermal conductivity value.

As a result, in the copper-clad laminate having the low dielectric constant, low dielectric loss and high thermal conductivity properties according to some embodiments of the present disclosure and the method for manufacturing the same, the insulator substrate has a high thermal conductivity value in a range of 1.92 to 18 W/mk, more preferably a thermal conductivity value in a range of 3 to 8 W/mK, while exhibiting a dielectric constant (Dk) of 4.9 or smaller and a dielectric loss (Df) of 0.008 or smaller as measured at 10 to 100GHz.

The effects of the present disclosure are not limited to the above-mentioned effects, and other effects as not mentioned will be clearly understood by those skilled in the art from the following detailed description.

### BRIEF DESCRIPTION OF DRAWINGS

FIG. 1 is a schematic diagram illustrating a copper-clad laminate having a low dielectric constant, low dielectric loss, and high thermal conductivity according to an embodiment of the present disclosure.
FIG. 2 is a schematic diagram showing an insulator substrate of FIG. 1.
FIG. 3 is a process flowchart illustrating a method for manufacturing a copper-clad laminate having a low dielectric constant, low dielectric loss, and high thermal conductivity according to an embodiment of the present disclosure.
FIG. 4 is an actual photograph showing a dielectric constant measuring device.
FIG. 5 is an actual photograph showing a thermal conductivity measuring device.
FIGS. 6 and 7 are graphs showing thermal conductivity measurement results of the copper-clad laminates manufactured according to Present Examples 1 and 2.
FIG. 8 and FIG. 9 are graphs showing thermal conductivity measurement results of the copper-clad laminates manufactured according to Present Example 3 and Present Example 4.
FIG. 10 is a graph of comparing results of the thermal conductivity measurement results of the copper-clad laminates manufactured according to Present Examples 1 to 4.

### DETAILED DESCRIPTIONS

Advantages and features of the present disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to completely inform the scope of the present disclosure to those of ordinary skill in the technical field to which the present disclosure belongs, and the present disclosure is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for illustrating embodiments of the present disclosure are illustrative, and the present disclosure is not limited thereto.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, regions, layers and/or periods, these elements, components, regions, layers and/or periods should not be limited by these terms. These terms are used to distinguish one element, component, region, layer or section from another element, component, region, layer or period. Thus, a first element, component, region, layer or section as described under could be termed a second element, component, region, layer or period, without departing from the spirit and scope of the present disclosure.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is no separate explicit description thereof.

It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for illustrating embodiments.

Further, in a specific case, a term may be arbitrarily selected by the applicant, and in this case, the detailed meaning thereof will be described in a corresponding description period. Therefore, the terms used in the description below should be understood based on not simply the name of the terms, but the meaning of the terms and the contents throughout the Detailed Descriptions.

Hereinafter, a copper-clad laminate having a low dielectric constant, low dielectric loss, and high thermal conductivity characteristics according to a preferred embodiment of the present disclosure will be described in detail with reference to the accompanying drawings.

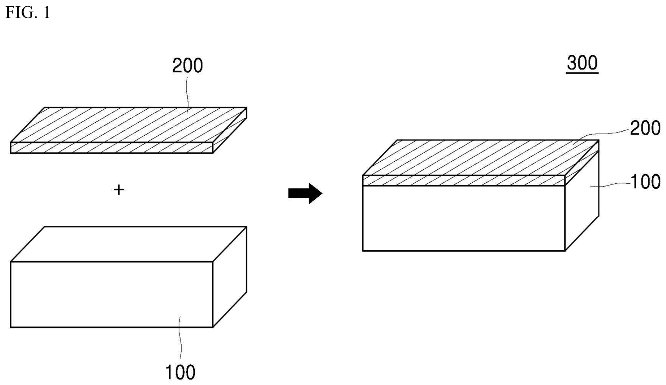

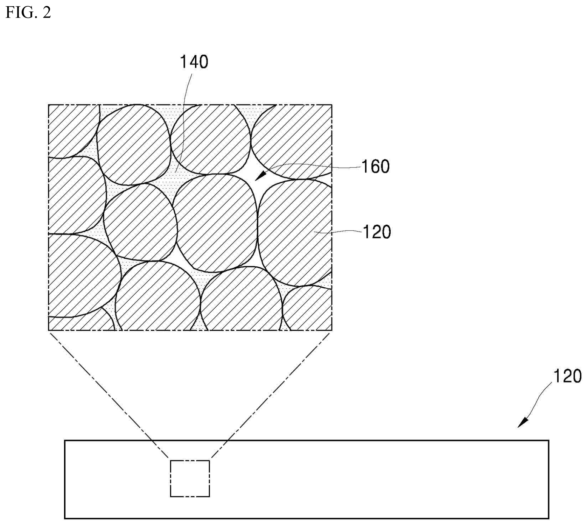

FIG. 1 is a schematic view of a copper-clad laminate having a low dielectric constant, low dielectric loss, and high thermal conductivity according to an embodiment of the present disclosure, and FIG. 2 is a schematic view of an insulator substrate of FIG. 1.

Referring to FIGS. 1 and 2, a copper-clad laminate 300 having a low dielectric constant, a low dielectric loss, and a high thermal conductivity according to an embodiment of the present disclosure includes an insulator substrate 100 and a copper foil layer 200.

In general, a circuit pattern may be formed on an insulator substrate using Ag ink. However, in this case, it is impossible to form a line width of the circuit pattern of 40 µm or smaller.

Accordingly, in accordance with the present disclosure, it is possible to implement a circuit pattern having a fine line width by attaching the copper foil layer 200 on the insulator substrate 100 and selectively etching the copper foil layer 200. In this regard, the copper foil layer 200 is illustrated as being attached only to an upper surface of the insulator substrate 100. However, embodiments of the present disclosure are not limited thereto. That is, the copper foil layer 200 may be attached to the upper surface and/or a lower surface of the insulator substrate 100.

In accordance with the present disclosure, the copper foil layer 200 may be made of a copper foil. However, embodiments of the present disclosure are not limited thereto, and copper foil layer 200 may be made of any metal material having excellent electrical conductivity without particular limitation thereto. Therefore, in accordance with the present disclosure, the copper foil layer 200 may be interpreted as a material layer made of a metal material.

As described above, the copper-clad laminate 300 having a low dielectric constant, low dielectric loss and high thermal conductivity according to some embodiments of the present disclosure has a laminate structure including the insulator substrate 100 having a low dielectric constant and high thermal conductivity and the copper-foil layer 200 laminated onto the insulator substrate 100.

In this regard, the copper-foil layer 200 attached onto the insulator substrate 100 may be subject to an etching process to selectively remove an unnecessary portion of the copper-foil layer 200 to design a circuit pattern having a line width of 40 µm or smaller, thereby forming the copper-clad laminate 300 having a low dielectric constant, low dielectric loss, and high thermal conductivity according to some embodiments of the present disclosure. This copper-clad laminate 300 may be used as a digital substrate.

The insulator substrate 100 may be manufactured by performing an inkjet-printing method on each of a ceramic ink composition containing ceramic particles 120 and a resin ink composition containing a resin 140. In this regard, more specifically, the inkjet-printing may include a drop-on-demand (DOD) method. When the insulator substrate 100 is manufactured using the drop-on-demand (DOD), it is easy to control an injection speed and an injection spacing, and thus it is possible to manufacture a complicated shape of a film with excellent accuracy and uniformity.

That is, the insulator substrate 100 of the present disclosure may be manufactured by spraying the ceramic ink composition containing the ceramic particles 120 in the drop-on-demand (DOD) manner to form a ceramic insulating film, and then spraying the resin ink composition containing the resin 140 on a top surface of the formed ceramic insulating film in the drop-on-demand (DOD) manner, such that the resin ink composition is impregnating into pores 160 defined between the ceramic particles 120 under the capillary phenomenon, and then heat-treating the ceramic insulating film impregnated with the resin ink composition at 140 to 200°C for 1 to 6 hours.

In this regard, a substrate (not shown) onto which the ceramic ink composition containing the ceramic particles 120 is applied may include one selected from a ceramic substrate, a semiconductor substrate, a metal substrate, a polymer film, and the like as commonly available. However, embodiments of the present disclosure are not limited thereto, and any general substrate may be used as the substrate (not shown) onto which the ceramic ink composition containing the ceramic particles 120 is applied.

Since a bonding force between the ceramic particles 10 is weak, the ceramic particles 120 are trapped in a network of the resin 140 using the resin 140 as a binder to manufacture the insulator substrate 100 made of a ceramic-resin-pore composite or a ceramic-resin composite.

The ceramic particles 120 may include at least one selected from Al₂O₃, AlN, SiO₂, BaTiO₃-based ceramic, SrTiO₃-based ceramic, PbTiO₃-based ceramic, ferrite, and Pb(Zr, Ti)O₃-based ceramic. However, embodiments of the present disclosure are not limited thereto, and any other ceramic particles may be used as the ceramic particles 120. it is more preferable to use Al₂O₃ particles as the ceramic particles 120.

The resin 140 contained in the resin ink composition may be made of a thermosetting polymer resin. More specifically, the resin 140 may include at least one selected from polyacrylates resin, epoxy resin, phenolic resin, polyamide resin, polyimide resin, unsaturated polyesters resin, polyphenylene ether resin (PPE), polyphenylene sulfide resin, cyanate ester resin, and benzocyclobutene (BCB). However, embodiments of the present disclosure are not limited thereto. Any commercially available thermosetting polymer resin may be used as the resin 40.

The insulator substrate 100 of the present disclosure described above includes 5 to 50 vol% of the resin 140, 0 to 40 vol% of the pores 160, and the remaining amount of the ceramic particles 140.

Accordingly, the insulator substrate 100 of the present disclosure may be made of a ceramic-resin-pore composite or a ceramic-resin composite.

As described above, in the insulator substrate 100 of the present disclosure, the pores 160 defined between the ceramic particles 120 may be filled with the resin 140 to form a ceramic-resin-pore composite. In this regard, adjusting the amount of the resin ink composition may allow the volume ratio of the pores 160 not filled with the resin 140 to be controlled. In this regard, when the volume ratio of the pores 160 is maintained to the maximum, dielectric properties may be improved while the thermal conductivity may be relatively lowered. Therefore, it is preferable to control the volume ratio of the pores 160 to 40 vol% or smaller.

In addition, the insulator substrate 100 of the present disclosure may be made of a ceramic-resin composite. The ceramic-resin composite structure may realize high thermal conductivity. In this case, the insulator substrate 100 of the present disclosure may include 5 to 60 vol% of the resin 140 and 40 to 95 vol% of the ceramic particles 120.

In general, when an insulator substrate made of a polymer material has a thermal conductivity (TC) of about 1 W/mK or greater, it is considered that the insulator substrate has excellent thermal conductivity. Most of commercially available polymer insulator substrates have a thermal conductivity value of 0.3 to 0.6 W/mK.

In order to replace the insulator substrate of the polymer material, the insulating substrate of a metal material manufactured by coating an insulating material on a metal base having high thermal conductivity has a thermal conductivity value of 2 to 7.5 W/mK. However, the insulating substrate of the metal material has a high thermal expansion coefficient, and thus has a disadvantage in that a lot of mechanical stress is applied to components mounted on the substrate. As described above, the insulating substrate made of the metal material has significantly different properties from those of the insulator substrate in which the ceramic particles are impregnated with the resin without the metal base.

That is, the resin ink composition impregnates into the pores 160 of the ceramic particles 120 using an inkjet printing method. The resulting structure is heat-treated, so that the resin 140 uniformly fills the pores 160 of the ceramic particles 120, thereby obtaining the insulator substrate 100 of the present disclosure which exhibits the high thermal conductivity value while having the low dielectric constant.

As a result, the insulator substrate 100 of the present disclosure has a high thermal conductivity value in a range of 1.92 to 18 W/mk, and more preferably a thermal conductivity value in a range of 3 to 8 W/mK, while exhibiting a dielectric constant (Dk) of 4.9 or smaller and a dielectric loss (Df) of 0.008 or smaller as measured at 10 to 100GHz.

Hereinafter, a method for manufacturing a copper-clad laminate having a low dielectric constant, low dielectric loss, and high thermal conductivity characteristics according to an embodiment of the present disclosure will be described with reference to the accompanying drawings.

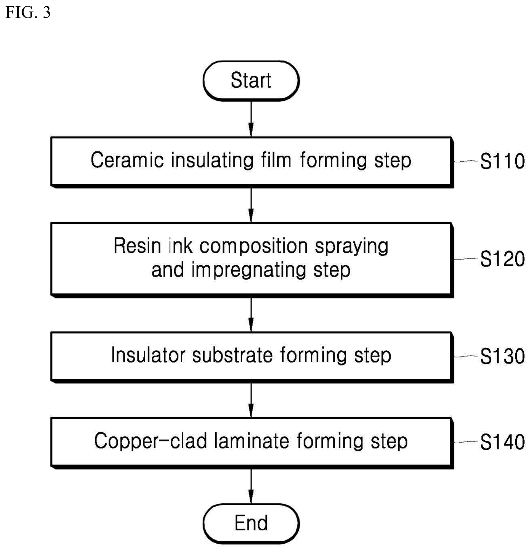

FIG. 3 is a process flowchart illustrating a method for manufacturing a copper-clad laminate having a low dielectric constant, low dielectric loss, and high thermal conductivity characteristics according to an embodiment of the present disclosure.

As shown in FIG. 3, the method for manufacturing the copper-clad laminate having a low dielectric constant, low dielectric loss, and high thermal conductivity according to an embodiment of the present disclosure includes a ceramic insulating film forming step S110, a resin ink composition spraying and impregnating step S120, an insulator substrate forming step S130, and a copper-clad laminate forming step S140.

### Ceramic insulating film formation

In the forming of the ceramic insulating film in S110, the ceramic ink composition containing the ceramic particles is coated in an inkjet printing manner to form the ceramic insulating film in which the ceramic particles are uniformly dispersed.

In this regard, the ceramic ink composition containing the ceramic particles may be coated on the substrate. In this case, the substrate may include any one selected from a ceramic substrate, a semiconductor substrate, a metal substrate, a polymer film, and the like as commonly used. However, embodiments of the present disclosure are not limited thereto, and any conventional substrate may be used as the substrate onto which the ceramic ink composition is applied.

In this step, the ceramic ink composition containing the ceramic particles may be prepared by mixing 5 to 20 vol% of the ceramic particles and 80 to 95vol% of a solvent with each other.

When the amount of ceramic particles added is out of 5 to 20 vol%, the dispersion stability of the ceramic ink composition may be deteriorated when the ceramic insulating film is formed, and thus the physical properties of the insulator substrate may be deteriorated.

In addition, it is preferable to use the ceramic particles having an average diameter of 1,000nm or smaller, more preferably to use the ceramic particles having an average diameter of 10 to 1,000nm, and most preferably to use the ceramic particles having an average diameter of 100 to 500nm. When the average diameter of the ceramic particles exceeds 1,000nm, dispersibility of the ceramic particles may be improved, whereas a filling rate of the ceramic particles may be lowered due to the clogging of the nozzle of the inkjet printing apparatus. For this reason, it is preferable to use a material having an average diameter of 1,000nm or smaller.

In addition, the ceramic particles may have various shapes such as a pellet shape, a plate shape, a circular shape, and the like. The original characteristics of the ceramic may be maintained using crystalline ceramic particles.

The ceramic particles 120 may include at least one selected from Al₂O₃, AlN, SiO₂, BaTiO₃-based ceramic, SrTiO₃-based ceramic, PbTiO₃-based ceramic, ferrite, and Pb(Zr, Ti)O₃-based ceramic. However, embodiments of the present disclosure are not limited thereto, and any other ceramic particles may be used as the ceramic particles 120. it is more preferable to use Al₂O₃ particles as the ceramic particles 120.

In addition, the solvent may include one or more selected from a hydrocarbon-based solvent, a chlorinated hydrocarbon-based solvent, a cyclic ether-based solvent, a ketone-based solvent, an alcohol, a polyalcohol-based solvent, an acetate-based solvent, an ether-based solvent of a polyalcohol, a terpene-based solvent, and the like.

For example, the solvent may include dimethylformamide (DMF), ethyl alcohol, ethylene glycol (EG), diethylene glycol (DEG), dibasic ester (DBE), carbitol acetate (CA), dipropylene glycol methyl ether (DPM or DPGME), butylcarbitol acetate (BCA), butylcarbitol (BC), texanol, terpitheol, butyl acrylate (BA), and the like. Further, distilled water may be used as the solvent.

In addition, in order to control a surface tension, a dispersant may be further added to the ceramic ink composition in an amount of 5 vol% or smaller. For example, the dispersant may include one or more selected from a nonionic surfactant, a cationic surfactant, an anionic surfactant, octyl alcohol, an acrylic polymer, and the like. However, embodiments of the present disclosure are not limited thereto.

In this step, the ceramic ink composition containing ceramic particles is coated by spraying the ceramic ink composition on the substrate at a constant speed and at constant pitches or spacings in each of an x-ais and a y-axis using a drop-on-demand (DOD) method of inkjet printing, thereby forming the ceramic insulating film in which ceramic particles are uniformly dispersed.

To this end, during inkjet printing, it is preferable to spray the ceramic ink composition at a first speed and a first pitch or spacing. In this case, it is preferable that the first speed of the inkjet printing is set to 1 to 30cm/s, and the first pitch or spacing is set to 10 to 60 µm along each of the y-axis and the x-axis.

### Spraying and impregnating resin ink composition

In the spraying and impregnating of the resin ink composition in S120, the resin ink composition containing the resin is sprayed on the ceramic insulating film using an inkjet printing method, thereby impregnating the resin ink composition into the pores defined between the ceramic particles.

The resin ink composition may include 5 to 20 vol% of the resin and 80 to 95 vol% of a solvent. When the content of the resin is greater than 5 to 20 vol%, the resin ink composition may not be uniformly impregnating into the pores of the ceramic insulating film.

Such a resin is a thermosetting polymer resin and binds to alumina nano powders, and may have excellent adhesive strength with the metal after curing and may maintain printability.

The resin 140 is a material binding to ceramic particles, has excellent adhesive strength after heat treatment, and may be able to maintain printability. To this end, the resin may be made of a thermosetting polymer resin. More specifically, the resin 140 may include at least one selected from polyacrylates resin, epoxy resin, phenolic resin, polyamide resin, polyimide resin, unsaturated polyesters resin, polyphenylene ether resin (PPE), polyphenylene sulfide resin, cyanate ester resin, and benzocyclobutene (BCB). However, embodiments of the present disclosure are not limited thereto. Any commercially available thermosetting polymer resin may be used as the resin 40.

In this step, the resin ink composition containing resin is sprayed using the inkjet printing method, such that the resin ink composition may be impregnated from a surface into an inside of the ceramic insulating film under a capillary phenomenon, and thus may fill the pores defined between the ceramic particles.

Accordingly, a spray amount of the resin ink composition containing the resin is adjusted, such that a porosity of the pores defined between the ceramic particles may be adjusted based on the amount of the resin ink composition impregnating into the ceramic insulating film.

In this regard, a temperature of the substrate to which the resin ink composition is sprayed may be in a range of room temperature to 140°C. In this case, the room temperature may be in a range of 1 to 40°C. However, embodiments of the present disclosure are not limited thereto. Accordingly, the pores may be filled with the resin contained in the resin ink composition impregnating into the ceramic insulating film.

In this step, the resin ink composition containing the ceramic resin is coated on the ceramic insulating film by spraying the resin ink composition on the ceramic insulating film at a constant speed and at constant pitches or spacings in each of an x-ais and a y-axis using the drop-on-demand (DOD) method of inkjet printing, such that the resin ink composition impregnates into the pores defined between the ceramic particles.

When inkjet printing the resin ink composition, it is preferable to spray the resin ink composition at a second speed and a second spacing. In this case, it is preferable that the second speed is equal to the first speed, and the second spacing is greater than the first spacing. It is preferable that the second speed of inkjet printing is set to 1 to 30cm/s, and the second pitch or spacing is set to 30 to 120 µm along each of the y-axis and the x-axis.

### Insulator substrate formation

In the forming of the insulator substrate in S130, the insulator substrate is formed by heat-treating the ceramic insulating film impregnated with the resin ink composition at 140 to 200°C for 1 to 6 hours.

In this step, the resin of the resin ink composition impregnating into the pores of the ceramic insulating film under the capillary phenomenon may be heat-treated and cured. That is, during the heat treatment process, the solvent of the resin ink composition impregnating into the ceramic insulating film is volatilized and removed, and the pores are filled only with the resin, thereby lowering the porosity of the pores defined between the ceramic particles.

When the heat treatment temperature is lower than 140°C or the heat treatment time is smaller than 1 hour, sufficient curing may not be performed, and there is a concern that the bonding force between the ceramic particles and the resin impregnating into the pores defined between the ceramic particles may be weakened. On the contrary, when the heat treatment temperature exceeds 200°C or the heat treatment time exceeds 6 hours, this may act as a factor that increases only a manufacturing cost and time without further increase in the effect, and thus is not economical.

The insulator substrate manufactured in the above process includes 5 to 50 vol% of the resin, 0 to 40 vol% of the pores, and the remaining amount of the ceramic particles.

Accordingly, the insulator substrate may be made of a ceramic-resin-pore composite, or may be made of a ceramic-resin composite.

As described above, the resin may impregnate into the pores in the ceramic particles to form the ceramic-resin-pore composite constituting the insulator substrate. In this regard, the volume ratio of the pores not filled with the resin may be controlled by adjusting the amount of the resin ink composition. In this regard, when the volume ratio of the pores is maintained to the maximum, the dielectric properties may be improved, whereas the thermal conductivity is relatively lowered. Therefore, it is preferable to control the volume ratio of the pores to 40 vol% or smaller.

In addition, the insulator substrate may be made of a ceramic-resin composite. In this case, the high thermal conductivity characteristics may be realized due to the ceramic-resin composite structure. In this regard, the insulator substrate of the present disclosure may include 5 to 60 vol% of the resin and 40 to 95 vol% of the ceramic particles.

### Copper-clad laminate formation

In the forming of the copper-clad laminate in S140, the copper-clad laminate is formed by laminating the copper-foil layer onto the insulator substrate.

In general, a circuit pattern may be formed on an insulator substrate using Ag ink. However, in this case, it is impossible to form a line width of the circuit pattern of 40 µm or smaller.

Accordingly, in accordance with the present disclosure, it is possible to implement a circuit pattern having a fine line width by attaching the copper foil layer 200 on the insulator substrate 100 and selectively etching the copper foil layer 200. In this regard, the copper foil layer 200 is illustrated as being attached only to an upper surface of the insulator substrate 100. However, embodiments of the present disclosure are not limited thereto. That is, the copper foil layer 200 may be attached to the upper surface and/or a lower surface of the insulator substrate 100.

In accordance with the present disclosure, the copper foil layer 200 may be made of a copper foil. However, embodiments of the present disclosure are not limited thereto, and copper foil layer 200 may be made of any metal material having excellent electrical conductivity without particular limitation thereto. Therefore, in accordance with the present disclosure, the copper foil layer 200 may be interpreted as a material layer made of a metal material.

As described above, the copper-clad laminate 300 having a low dielectric constant, low dielectric loss and high thermal conductivity according to some embodiments of the present disclosure has a laminate structure including the insulator substrate 100 having a low dielectric constant and high thermal conductivity and the copper-foil layer 200 laminated onto the insulator substrate 100.

In this regard, the copper-foil layer 200 attached onto the insulator substrate 100 may be subject to an etching process to selectively remove an unnecessary portion of the copper-foil layer 200 to design a circuit pattern having a line width of 40 µm or smaller, thereby forming the copper-clad laminate 300 having a low dielectric constant, low dielectric loss, and high thermal conductivity according to some embodiments of the present disclosure. This copper-clad laminate 300 may be used as a digital substrate.

In this way, the present disclosure realizes a copper-clad laminate having a low dielectric constant, low dielectric loss and high thermal conductivity properties, and a method for manufacturing the same, wherein an insulator substrate having a low dielectric constant, low dielectric loss and high thermal conductivity values is laminated onto a copper-foil layer and a portion of the copper-foil layer is patterned using selective etching such that a circuit pattern having a line width of 40 µm or smaller is designed, such that the copper-clad laminate is used as a digital substrate.

In addition, in the copper-clad laminate having a low dielectric constant, low dielectric loss, and high thermal conductivity properties and the method for manufacturing the same according to an embodiment of the present disclosure, the pores defined between the ceramic particles are filled with the resin ink composition by impregnating the pores formed between the ceramic particles with the resin ink composition using the inkjet printing method, and the resin ink composition is subject to the heat treatment, such that the resin uniformly fills the pores formed between the ceramic particles, thereby manufacturing the insulator substrate having the low dielectric constant and exhibiting the high thermal conductivity value.

As a result, in the copper-clad laminate having the low dielectric constant, low dielectric loss and high thermal conductivity properties according to some embodiments of the present disclosure and the method for manufacturing the same, the insulator substrate has a high thermal conductivity value in a range of 1.92 to 18 W/mk, more preferably a thermal conductivity value in a range of 3 to 8 W/mK, while exhibiting a dielectric constant (Dk) of 4.9 or smaller and a dielectric loss (Df) of 0.008 or smaller as measured at 10 to 100GHz.

### Examples

Hereinafter, the configuration and operation of the present disclosure will be described in more detail through preferred examples of the present disclosure. However, the following examples are presented merely by way of example and cannot be interpreted as limiting the present disclosure in any sense.

The contents not described herein may be sufficiently technically inferred by those skilled in this technical field, and thus the description thereof will be omitted.

### 1. Manufacturing copper-clad laminate;

### Present Example 1

A ceramic ink composition prepared by mixing 10 vol% of Al₂O₃ powders (Sumitomo, AKP-30, D₅₀=250nm) and 90 vol% of ethylene glycol with each other and stirring the mixture at a speed of 500rpm for 30 minutes was coated on the substrate in an inkjet printing manner to prepare a ceramic insulating film in which Al₂O₃ powders were uniformly dispersed.

In this regard, the ink jetting was performed uniformly without the occurrence of satellite jetting by jetting the ceramic ink drops onto the substrate while maintaining the ink printing speed of the ceramic ink composition at 30cm/s. In this case, each of x-axis and y-axis pitch values of the ceramic ink was 50 µm, the printing frequency had a value of 1,000 Hz, and the temperature of the substrate was maintained at 120°C.

Next, a resin ink composition prepared by mixing 10 vol% of epoxy resin and 90 vol% of dipropylene glycol methyl ether (DPM or DPGME) with each other and stirring the mixture at a speed of 500rpm for 30 minutes was sprayed on the ceramic insulating film in an inkjet printing manner, thereby impregnating the resin ink composition into the pores of the ceramic particles.

In this regard, the resin ink drops were jetted onto the ceramic insulating film while the ink printing speed of the resin ink composition was maintained at 30cm/s, thereby uniformly performing ink jetting without the occurrence of satellite jetting. In this regard, each of the x-axis and y-axis pitch values of the resin ink composition was 75 µm, the frequency had a value of 1,000 Hz, and the temperature of the substrate was maintained at 30°C.

Next, the ceramic insulating film impregnated with the resin ink composition was heat-treated at 180°C for 6 hours to prepare the insulator substrate made of a ceramic-resin porous composite having the volume ratios of the components as shown in Table 1.

Next, a copper foil having a thickness of 10 µm was laminated onto the insulator substrate to manufacture the copper-clad laminate.

### Present Example 2

A ceramic ink composition prepared by mixing 10 vol% of Al₂O₃ powders (Sumitomo, AKP-30, D₅₀=250nm) and 90 vol% of ethylene glycol with each other and stirring the mixture at a speed of 500rpm for 30 minutes was coated on the substrate in an inkjet printing manner to prepare a ceramic insulating film in which Al₂O₃ powders were uniformly dispersed.

In this regard, the ink jetting was performed uniformly without the occurrence of satellite jetting by jetting the ceramic ink drops onto the substrate while maintaining the ink printing speed of the ceramic ink composition at 30cm/s. In this case, each of x-axis and y-axis pitch values of the ceramic ink was 25 µm, the printing frequency had a value of 1,000 Hz, and the temperature of the substrate was maintained at 120°C.

Next, a resin ink composition prepared by mixing 10 vol% of epoxy resin and 90 vol% of dipropylene glycol methyl ether (DPM or DPGME) with each other and stirring the mixture at a speed of 500rpm for 30 minutes was sprayed on the ceramic insulating film in an inkjet printing manner, thereby impregnating the resin ink composition into the pores of the ceramic particles.

In this regard, the resin ink drops were jetted onto the ceramic insulating film while the ink printing speed of the resin ink composition was maintained at 30cm/s, thereby uniformly performing ink jetting without the occurrence of satellite jetting. In this regard, each of the x-axis and y-axis pitch values of the resin ink composition was 50 µm, the frequency had a value of 1,000 Hz, and the temperature of the substrate was maintained at 60°C.

Next, the ceramic insulating film impregnated with the resin ink composition was heat-treated at 180°C for 6 hours to prepare the insulator substrate made of a ceramic-resin porous composite having the volume ratios of the components as shown in Table 1.

Next, a copper foil having a thickness of 10 µm was laminated onto the insulator substrate to manufacture the copper-clad laminate.

### Present Example 3

A ceramic ink composition prepared by mixing 10 vol% of Al₂O₃ powders (Sumitomo, AKP-30, D₅₀=250nm) and 90 vol% of ethylene glycol with each other and stirring the mixture at a speed of 500rpm for 30 minutes was coated on the substrate in an inkjet printing manner to prepare a ceramic insulating film in which Al₂O₃ powders were uniformly dispersed.

In this regard, the ink jetting was performed uniformly without the occurrence of satellite jetting by jetting the ceramic ink drops onto the substrate while maintaining the ink printing speed of the ceramic ink composition at 30cm/s. In this case, each of x-axis and y-axis pitch values of the ceramic ink was 40 µm, the printing frequency had a value of 1,000 Hz, and the temperature of the substrate was maintained at 120°C.

Next, a resin ink composition prepared by mixing 10 vol% of epoxy resin and 90 vol% of dipropylene glycol methyl ether (DPM or DPGME) with each other and stirring the mixture at a speed of 500rpm for 30 minutes was sprayed on the ceramic insulating film in an inkjet printing manner, thereby impregnating the resin ink composition into the pores of the ceramic particles.

In this regard, the resin ink drops were jetted onto the ceramic insulating film while the ink printing speed of the resin ink composition was maintained at 30cm/s, thereby uniformly performing ink jetting without the occurrence of satellite jetting. In this regard, each of the x-axis and y-axis pitch values of the resin ink composition was 40 µm, the frequency had a value of 1,000 Hz, and the temperature of the substrate was maintained at 30°C.

Next, the ceramic insulating film impregnated with the resin ink composition was heat-treated at 190°C for 6 hours to prepare the insulator substrate made of a ceramic-resin porous composite having the volume ratios of the components as shown in Table 1.

Next, a copper foil having a thickness of 10 µm was laminated onto the insulator substrate to manufacture the copper-clad laminate.

### Present Example 4

A ceramic ink composition prepared by mixing 10 vol% of Al₂O₃ powders (Sumitomo, AKP-30, D50=250nm) and 90 vol% of ethylene glycol with each other and stirring the mixture at a speed of 500rpm for 30 minutes was coated on the substrate in an inkjet printing manner to prepare a ceramic insulating film in which Al₂O₃ powders were uniformly dispersed.

In this regard, the ink jetting was performed uniformly without the occurrence of satellite jetting by jetting the ceramic ink drops onto the substrate while maintaining the ink printing speed of the ceramic ink composition at 30cm/s. In this case, x-axis and y-axis pitch values of the ceramic ink was 20 µm and 50 µm, the printing frequency had a value of 1,000 Hz, and the temperature of the substrate was maintained at 120°C.

Next, a resin ink composition prepared by mixing 10 vol% of epoxy resin and 90 vol% of dipropylene glycol methyl ether (DPM or DPGME) with each other and stirring the mixture at a speed of 500rpm for 30 minutes was sprayed on the ceramic insulating film in an inkjet printing manner, thereby impregnating the resin ink composition into the pores of the ceramic particles.

In this regard, the resin ink drops were jetted onto the ceramic insulating film while the ink printing speed of the resin ink composition was maintained at 30cm/s, thereby uniformly performing ink jetting without the occurrence of satellite jetting. In this regard, each of the x-axis and y-axis pitch values of the resin ink composition was 50 µm, the frequency had a value of 1,000 Hz, and the temperature of the substrate was maintained at 30°C.

Next, the ceramic insulating film impregnated with the resin ink composition was heat-treated at 180°C for 6 hours to prepare the insulator substrate made of a ceramic-resin porous composite having the volume ratios of the components as shown in Table 1.
Next, a copper foil having a thickness of 10 µm was laminated onto the insulator substrate to manufacture the copper-clad laminate.

**Table 1**

| **Examples** | **Resin (vol%)** | **Pores (vol%)** | **Ceramic particles (vol%)** |
|---|---|---|---|
| **Present Example 1** | **10** | **30** | **60** |
| **Present Example 2** | **20** | **20** | **60** |
| **Present Example 3** | **30** | **10** | **60** |
| **Present Example 4** | **40** | **0** | **60** |

### 2. Evaluation of dielectric properties and thermal conductivity

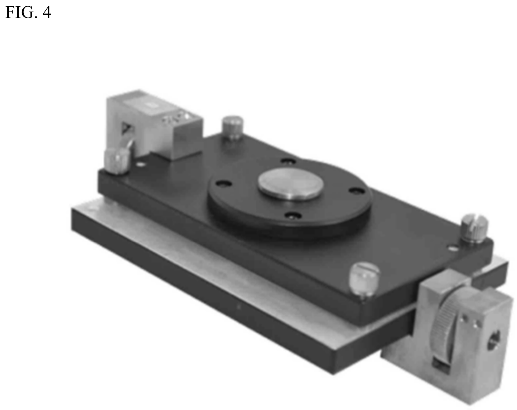

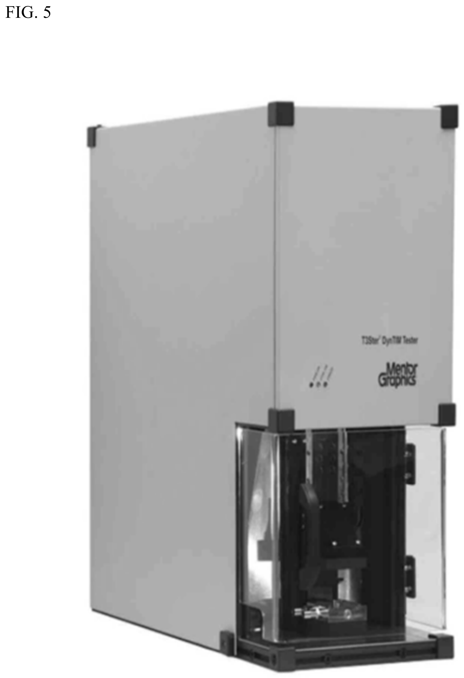

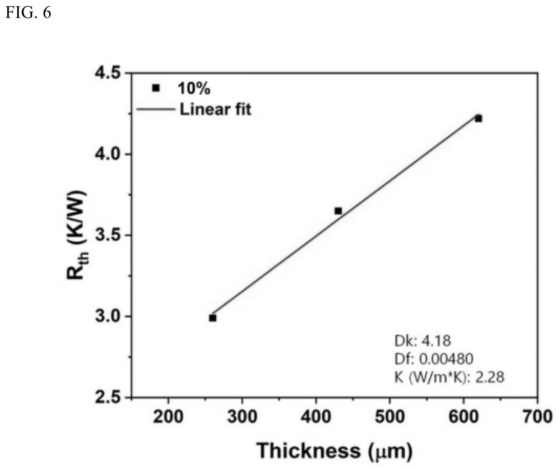

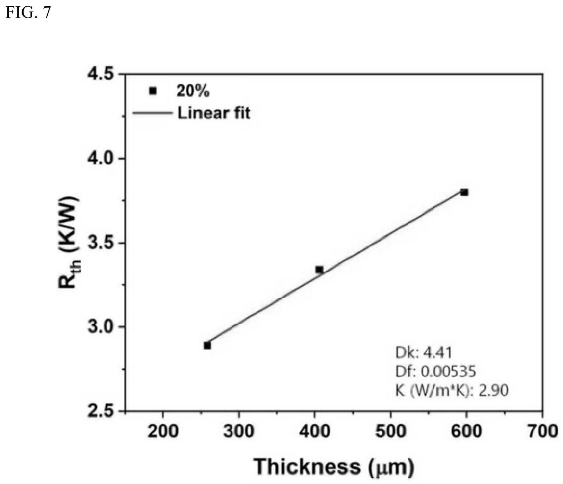

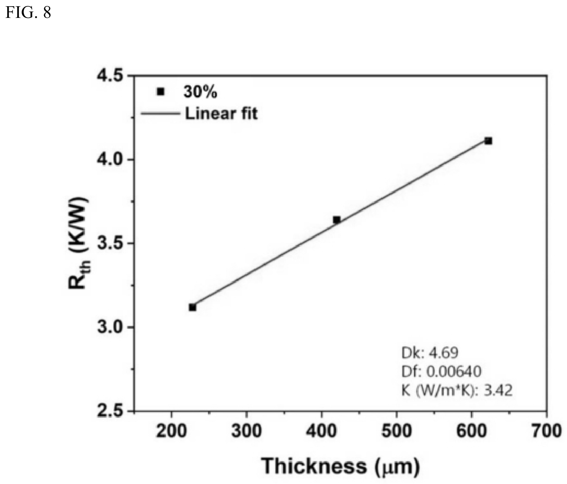

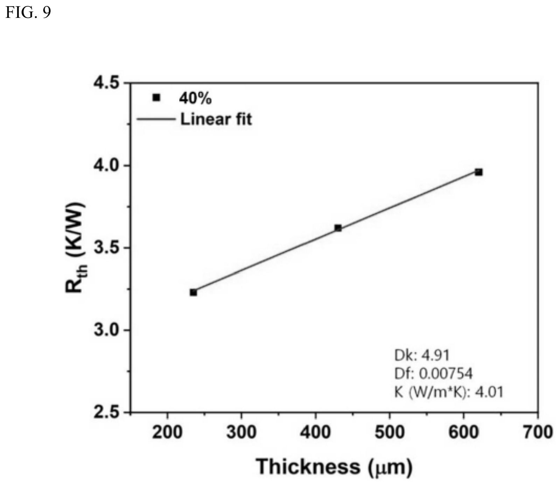

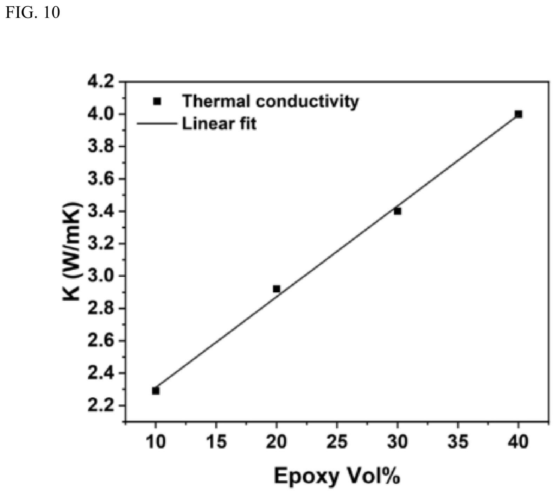

Table 2 shows the results of measuring the dielectric properties and the thermal conductivity of the copper-clad laminates manufactured according to Present Examples 1 to 4, FIG. 4 is an actual photograph showing a dielectric constant measuring device, and FIG. 5 is an actual photograph showing a thermal conductivity measuring device. In addition, FIGS. 6 and 7 are graphs showing thermal conductivity measurement results of the copper-clad laminates manufactured according to Present Example 1 and Present Example 2, FIGS. 8 and 9 are graphs showing thermal conductivity measurement results of the copper-clad laminates manufactured according to Present Example 3 and Present Example 4, and FIG. 10 is a graph showing a comparison of the thermal conductivity measurement results of the copper-clad laminates manufactured according to Present Examples 1 to 4.

### (1) Dielectric Properties (Dk, Df)

Dk and Df were measured using SPDR (Split Post Dielectric Resonators) (measurement frequency: 10GHz) equipment of keysight company as shown in FIG. 3.

### (2) Thermal Conductivity (K)

The K was measured using T3Ster DynTIM Tester equipment (measurement temperature: 25°C) from cadgraphics company as shown in FIG. 4.

**Table 2**

| **Examples** | **Dielectric constant (Dk)** | **Dielectric loss (Df)** | **Thermal conductivity (K, 25°C)** |
|---|---|---|---|
| **Present Example 1** | **4.2023** | **0.00502** | **2.28** |
| **Present Example 2** | **4.4144** | **0.00535** | **2.90** |
| **Present Example 3** | **4.6889** | **0.00640** | **3.42** |
| **Present Example 4** | **4.9146** | **0.00754** | **4.01** |

As shown in Table 1 and Table 2, and FIGS. 4 and 5, it was identified that the copper-clad laminates manufactured according to Present Examples 1 and 2 exhibited high thermal conductivity values of 1.92 W/mK or higher while maintaining low dielectric constant (Dk) and dielectric loss (Df) values.

On the other hand, it was identified that the copper-clad laminates prepared according to Present Examples 3 and 4 exhibited a high thermal conductivity value due to the addition of the large amount of the resin, while the dielectric constant (Dk) and dielectric loss (Df) values were slightly high.

As shown in FIGS. 6 to 10, it was identified that in the copper-clad laminates manufactured according to Present Examples 1 to 4, the thermal conductivity value tends to increase linearly as the content of the epoxy resin increases, whereas the dielectric constant (Dk) and the dielectric loss (Df) value also increase as the content of the epoxy resin increases. Thus, it was determined that it is preferable to optimize the content of the epoxy resin.

Although the embodiments of the present disclosure have been described in more detail with reference to the accompanying drawings, the present disclosure is not necessarily limited to the embodiments, and may be modified in a various manner within the scope of the technical spirit of the present disclosure. Accordingly, the embodiments as disclosed in the present disclosure are intended to describe rather than limit the technical idea of the present disclosure, and the scope of the technical idea of an embodiment of the present disclosure is not limited by these embodiments. Therefore, it should be understood that the embodiments described above are not restrictive but illustrative in all respects. In addition, even though the effects according to the configuration of the present disclosure are not explicitly described while illustrating the embodiment of the present disclosure, it is obvious that the predictable effect therefrom should also be recognized.

## Claims

1. A method for manufacturing a copper-clad laminate having a low dielectric constant, low dielectric loss and high thermal conductivity, the method comprising:
(a) injecting and coating a ceramic ink composition containing ceramic particles in an inkjet printing manner to form a ceramic insulating film having the ceramic particles uniformly dispersed therein;
(b) injecting a resin ink composition containing a resin onto the ceramic insulating film in an inkjet printing manner such that the resin ink composition impregnates into pores defined between the ceramic particles;
(c) heat-treating the ceramic insulating film impregnated with the resin ink composition at 140 to 200°C for 1 to 6 hours, thereby forming an insulator substrate; and
(d) laminating a copper foil layer on the insulator substrate to form the copper-clad laminate,
wherein the insulator substrate has a thermal conductivity value in a range of 1.92 to 18 W/mk.

2. The method for manufacturing the copper-clad laminate having the low dielectric constant, low dielectric loss and high thermal conductivity of claim 1, wherein in (a), the inkjet printing is carried out under a temperature of 80 to 140°C.

3. The method for manufacturing the copper-clad laminate having the low dielectric constant, low dielectric loss and high thermal conductivity of claim 1, wherein in (a), the ceramic particles include at least one selected from Al₂O₃, AlN, SiO₂, BaTiO₃-based ceramic, SrTiO₃-based ceramic, PbTiO₃-based ceramic, ferrite, and Pb(Zr, Ti)O₃-based ceramic.

4. The method for manufacturing the copper-clad laminate having the low dielectric constant, low dielectric loss and high thermal conductivity of claim 3, wherein the ceramic particles have an average diameter of 10 to 1,000nm.

5. The method for manufacturing the copper-clad laminate having the low dielectric constant, low dielectric loss and high thermal conductivity of claim 3, wherein in (a), the ceramic ink composition is injected at a first speed and at a first spacing,
wherein in the (b), the resin ink composition is injected at a second speed and at a second spacing,
wherein the first and second speeds are equal to each other, and the second spacing is greater than the first spacing.

6. The method for manufacturing the copper-clad laminate having the low dielectric constant, low dielectric loss and high thermal conductivity of claim 1, wherein in (b), the resin includes at least one selected from polyacrylates resin, epoxy resin, phenolic resin, polyamide resin, polyimide resin, unsaturated polyester resin, polyphenylene ether resin (PPE), polyphenylenesulfides resin, cyanate ester resin, and benzocyclobutene (BCB).

7. The method for manufacturing the copper-clad laminate having the low dielectric constant, low dielectric loss and high thermal conductivity of claim 1, wherein the insulator substrate formed in (c) includes:
5 to 50 vol% of the resin;
0 to 40 vol% of the pores; and
the ceramic particles as a remainder.

8. The method for manufacturing the copper-clad laminate having the low dielectric constant, low dielectric loss and high thermal conductivity of claim 1, wherein a dielectric constant (Dk) and a dielectric loss (Df) of the insulator substrate measured after (d) and at 10 to 100GHz satisfy the following: Dk is 4.9 or smaller and Df is 0.008 or smaller.

9. The method for manufacturing the copper-clad laminate having the low dielectric constant, low dielectric loss and high thermal conductivity of claim 1, wherein the method further comprises performing selective etching of the copper foil layer such that the copper foil layer is patterned into a circuit pattern having a line width of 40 µm or smaller.

10. A copper-clad laminate comprising:
an insulator substrate comprising a ceramic insulating film having ceramic particles uniformly dispersed therein and a resin ink composition present in pores defined between the ceramic particles, and a copper foil layer laminated onto the insulator substrate,
wherein the insulator substrate includes 5 to 50 vol% of the resin of the resin ink composition, 0 to 40 vol% of the pores, and the ceramic particles as a remainder,
wherein the ceramic particles have an average diameter of 10 to 1,000nm,
wherein the insulator substrate has a thermal conductivity value in a range of 1.92 to 18 W/mk.

11. The copper-clad laminate of claim 10, wherein a dielectric constant (Dk) and a dielectric loss (Df) of the insulator substrate measured at 10 to 100GHz satisfy the following: Dk is 4.9 or smaller and Df is 0.008 or smaller.

12. The copper clad laminate of claim 10 or 11, wherein the copper clad laminate has been manufactured by means of the method of any one of claims 1-9.
